# FASCICULE DE BREVET EUROPEEN

(11) **EP 0 434 502 B1**
(45) Date de publication et mention de la délivrance du brevet: **22.05.1996**
(21) Numéro de dépôt: 90403542.5
(22) Date de dépôt: 12.12.1990
(51) Int. Cl.: H01L 27/148

(54) **Photosenseur hybride**
Hybrider Photosensor
Hybrid photosensor

(30) Priorité: 19.12.1989 FR 8916788
(43) Date de publication de la demande: 26.06.1991
(73) Titulaire: THOMSON-CSF SEMICONDUCTEURS SPECIFIQUES, 75008 Paris (FR)
(72) Inventeur: Thenoz, Yves, F-92045 Paris la Défense (FR); Coutures, Jean-Louis, F-92045 Paris la Défense (FR)
(74) Mandataire: Guérin, Michel

(56) Documents cités:
- EP-A- 0 098 191
- PATENT ABSTRACTS OF JAPAN, vol. 9, no. 230 (E-343)[1953], 17 septembre 1985, Tokyo, JP; & JP-A-60 084 868

## Description

L'invention concerne les photosenseurs hybrides, c'est-à-dire des capteurs photosensibles dont les éléments photosensibles sont réalisés sur un premier substrat tandis que le circuit de lecture des signaux électriques issus des éléments photosensibles est réalisé sur un deuxième substrat.

Ce type de photosenseur hybride est utilisé par exemple pour réaliser des matrices de prise de vue en infrarouge: le premier substrat porte une mosaïque de détecteurs infrarouges qui sont par exemple des diodes photovoltaïques réalisées par diffusions superficielles locales d'un dopant (type N par exemple) dans un substrat de type de conductivité opposé (type P). Le deuxième substrat porte un circuit de lecture constitué par une mosaïque de circuits de lecture élémentaires correspondant chacun à un détecteur du premier substrat. Les circuits de lecture du deuxième substrat comportent, pour chaque détecteur du premier substrat, au moins une diode d'entrée suivie d'une grille d'injection qui lui est adjacente, et une grille de stockage adjacente à la grille d'injection mais non adjacente à la diode d'entrée.

Les détecteurs du premier substrat sont connectés chacun à une diode d'entrée respective du deuxième substrat.

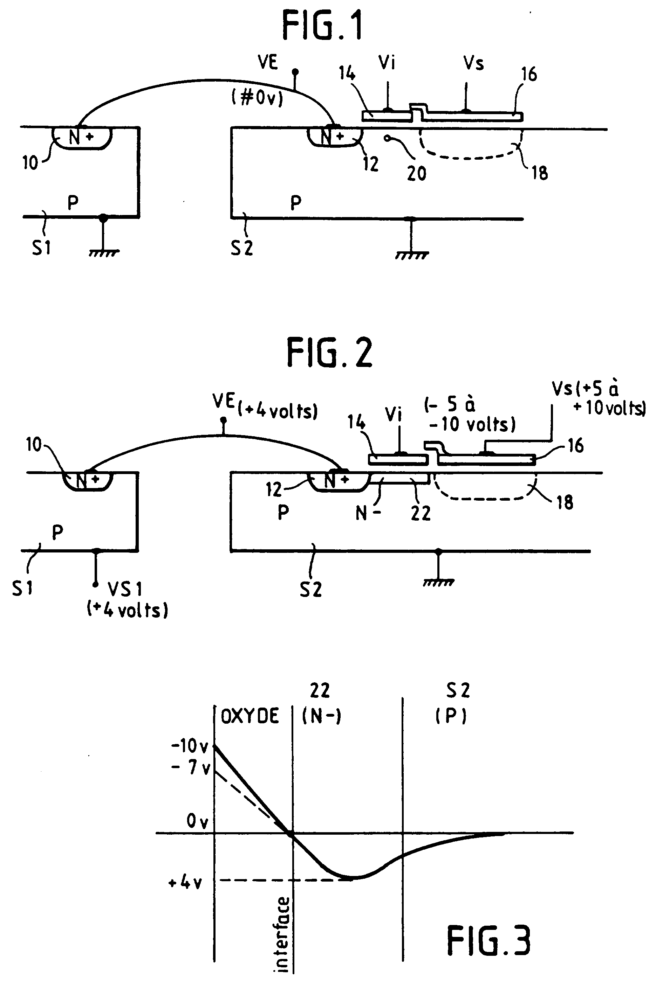

La structure classique d'un circuit de lecture élémentaire du deuxième substrat est représentée sur la figure 1 avec, sous la forme symbolique d'un fil conducteur de liaison, sa connexion avec un détecteur photovoltaïque du premier substrat (voir par exemple EP-A-0 098 191).

Le premier substrat, de type P par exemple, est désigné par S1 et le deuxième, également de type P, par S2. Le détecteur photovoltaïque est une diode constituée par une région 10 de type N⁺ diffusée dans le premier substrat de type opposé. Cette région est reliée électriquement à une région 12 diffusée dans le deuxième substrat, cette région 12 étant aussi de type opposé au substrat dans lequel elle est diffusée.

La région 12 constitue une entrée du circuit de lecture élémentaire réalisé sur le substrat S2.

Ce circuit de lecture élémentaire comprend une diode (région N⁺ 12 diffusée dans le substrat S2 de type P) une grille d'injection 14 adjacente à la région 12, et une grille de stockage 16 adjacente à la grille d'injection 14 mais non adjacente à la région 12.

Le circuit de lecture fonctionne de la manière suivante: les substrats S1, S2 sont reliés, par exemple par leur face arrière, à une masse électrique définissant un potentiel zéro; le potentiel de polarisation VE de la région 10 (diode photovoltaïque) est proche de zéro pour permettre un fonctionnement correct du détecteur; le potentiel de polarisation de la région 12 est donc également très proche de zéro et permet, grâce à la grille d'injection adjacente 14, d'injecter le courant de la diode photovoltaïque vers une région de stockage 18 située au-dessous de la grille de stockage 16; cette injection se produit à travers un canal 20 constitué par le substrat au-dessous de la grille d'injection.

La région de stockage 18 est une région du substrat dans laquelle des charges injectées par la diode d'entrée peuvent s'accumuler localement du fait qu'un puits de potentiel créé dans cette région empêche (temporairement) l'évacuation de ces charges. Le puits de potentiel est créé par l'application sur la grille de stockage d'une tension Vs suffisamment positive (par exemple +5 à +10 volts) par rapport au substrat. Lorsqu'on désire l'évacuation des charges ainsi accumulées, on modifie le potentiel de la grille de stockage par rapport au potentiel dans une région voisine (non représentée) vers laquelle on veut évacuer les charges. Le circuit de lecture est en fait un circuit de conversion du courant photovoltaïque en un paquet de charges accumulées pendant une durée d'éclairement déterminée du capteur photosensible.

Le potentiel Vi de la grille d'injection 14, pendant la phase d'accumulation de charges sous la grille de stockage, est choisi en fonction des paramètres de fabrication du circuit, pour que l'injection de charges de la diode d'entrée 12 vers la région de stockage soit possible mais aussi pour que cette injection résulte bien du courant photovoltaïque dans la plage de polarisation optimale, c'est-à-dire celle qui correspond à un courant généré par la diode photovoltaïque le plus indépendant de sa polarisation.

En pratique, la grille d'injection est polarisée par une tension continue Vi plaçant le canal 20 qu'elle surplombe en régime de faible inversion, c'est-à-dire que le canal 20 est légèrement conducteur. Le potentiel de la région 12 s'établit de telle sorte que le courant d'injection de cette région sous la grille d'injection égale le courant de la diode photovoltaïque.

Si la polarisation Vi est trop forte, le courant de la diode photovoltaïque devient trop fort pour la capacité du circuit, le courant généré diminue et devient plus dépendant de la tension de polarisation.

Il est donc nécessaire de contrôler exactement le potentiel de la région de canal 20 qui définit la polarisation de la diode photovoltaïque.

Le potentiel de la région de canal 20 n'est contrôlable que par l'intermédiaire de la grille d'injection 14, qui est reliée à une source de tension de polarisation Vi pendant la phase d'injection. Mais si le potentiel Vi est bien déterminé par cette source de tension, le potentiel dans le canal à proximité de la région N⁺ 12 dépend de beaucoup de facteurs: dopage du canal, épaisseur d'isolant de grille et nature de l'isolant, et surtout il dépend des charges électriques piégées dans l'isolant de grille ou à l'interface entre l'isolant et le semiconducteur.

Ces charges piégées varient dans le temps et varient d'un point à un autre de la mosaïque de circuits de lecture élémentaires quand le dispositif se trouve dans un environnement de radiations.

Il en résulte une non uniformité dans le temps et dans l'espace du courant généré par les diodes photovoltaïques.

L'invention a pour but d'éliminer le risque d'inhomogénéité des courants injectés correspondant aux différents points de la mosaïque. Elle a aussi pour but de limiter ces courants à une valeur acceptable.

Selon l'invention, on propose un photosenseur hybride comprenant un premier substrat semiconducteur portant des éléments photosensibles et un deuxième substrat semiconducteur comprenant, en correspondance avec chaque élément photosensible du premier substrat, un circuit de lecture pour convertir le courant issu de l'élément photosensible en paquets de charges, le circuit de lecture comportant une diode d'entrée constituée par une région semiconductrice diffusée à l'intérieur du deuxième substrat et de type de conductivité opposé au substrat, une grille d'injection adjacente à la diode d'entrée, et une grille de stockage adjacente à la grille d'injection et non adjacente à la diode d'entrée, caractérisé en ce que le deuxième substrat est dopé superficiellement au-dessous de la grille d'injection avec une impureté du type opposé au substrat, en ce que la diode d'entrée est reliée à une source de tension de polarisation positive par rapport au deuxième substrat, pour un deuxième substrat de type P, et en ce que la grille d'injection est reliée à une source de tension de polarisation suffisamment négative par rapport au deuxième substrat de type P, de façon à créer à la surface dudit deuxième substrat, sous la grille d'injection, une accumulation de porteurs libres du type de conductivité de base du deuxième substrat, les sens des potentiels étant inversés dans le cas d'un deuxième substrat de type N.

Le dopage au dessous de la grille d'injection est plus faible que dans la région dopée constituant avec le substrat la diode d'entrée. Par exemple, si le dopage dans la diode d'entrée est de 10¹ atomes par centimètre cube, le dopage peut être de 10¹⁶ atomes par centimètre cube dans la région sous la grille d'injection. La région sous la grille de stockage est de type P; mais elle peut toutefois être superficiellement dopée de type opposé au substrat, à une concentration semblable à celle qui règne sous la grille d'injection.

La tension négative élevée appliquée à la grille d'injection est par exemple comprise entre -5 et -10 volts par rapport au deuxième substrat. Elle est en tout cas suffisante pour tirer jusqu'à zéro volt (ou tendre à tirer au dessous de zéro volt) le potentiel à l'interface entre le semiconducteur au dessous de la grille d'injection. On expliquera ci-après comment cela entraîne une immunité contre les risques d'absence d'uniformité dans le temps et dans l'espace du courant généré par les éléments du photosenseur.

Le potentiel de la diode d'entrée par rapport au substrat s'équilibre de façon à ce que le courant photovoltaïque égale le courant d'injection sous la grille d'injection. Le premier substrat est de préférence porté à une tension positive de plusieurs volts par rapport au deuxième substrat et proche du potentiel de la diode d'entrée. Mais le potentiel du premier substrat peut dans certains cas être le même que celui du deuxième.

D'autres caractéristiques et avantages de l'invention apparaîtront à la lecture de la description détaillée qui suit et qui est faite en référence aux dessins annexés dans lesquels:
- la figure 1 représente un photosenseur hybride de la technique antérieure;
- la figure 2 représente un photosenseur hybride selon l'invention.
- la figure 3 représente un diagramme de distribution de potentiels dans le canal sous la grille d'injection.

Le photosenseur représenté à la figure 2 est très similaire à celui de la figure 1, mais il en diffère sur deux points essentiels qui sont d'une part la présence d'une région dopée (dopage dans le sens de la déplétion, c'est-à-dire dans le sens d'une inversion du type de conductivité du substrat) sous la grille d'injection, et d'autre part les valeurs de potentiels de polarisation appliqués en divers points.

Le photosenseur comprend donc encore un premier substrat S1 et un deuxième substrat S2. Dans l'exemple représenté ce sont deux substrats de silicium de type P, mais ils pourraient être de type N et ils pourraient être en matériaux différents du silicium; par exemple le premier substrat peut être en semiconducteur de la classe III-V (arséniure de gallium, phosphure d'indium) ou de la classe II-VI, notamment pour la réalisation de photosenseurs infrarouges.

Par substrat de type P on entend au moins une couche de type P dans laquelle est diffusée d'une part une jonction photovoltaïque (premier substrat) et d'autre part une jonction formant avec le substrat une diode d'entrée d'un circuit de lecture (deuxième substrat). Mais on doit comprendre que cette couche ne forme pas forcément le support matériel principal sur lequel sont réalisés d'une part les éléments photosensibles et d'autre part les circuits de lecture: le support matériel peut très bien être un corps isolant sur lequel est formée une couche semiconductrice et c'est alors cette dernière couche qu'on appellera substrat.

Comme à la figure 1, le premier substrat S1 porte les éléments photosensibles qui peuvent être disposés en ligne ou en matrice. Un seul élément est représenté sur la figure 2 pour simplifier. Cet élément est figuré schématiquement par une jonction photovoltaïque formée par une région semiconductrice 10 diffusée superficiellement dans le substrat S1 et de type de conductivité opposé au substrat.

Le deuxième substrat S2 porte les circuits de lecture élémentaires correspondant chacun à un élément photosensible respectif du premier substrat S1. Un seul circuit de lecture est représenté pour simplifier.

Le circuit de lecture du deuxième substrat S2 comporte une diode d'entrée constituée par une région 12 diffusée superficiellement dans le substrat S2 et de type de conductivité opposé au substrat. La diode d'entrée du substrat S2 est reliée électriquement à la diode photovoltaïque du substrat S1. Ici, la liaison électrique est directe entre un contact pris sur la région 10 et un contact pris sur la région 12. La liaison est symbolisée par un fil conducteur, mais peut être réalisée par tout autre moyen comme par exemple par l'intermédiaire de billes conductrices soudées chacune sur une région 10 et une région 12 en vis-à-vis, les deux substrats étant disposés en regard face à face.

Le circuit de lecture du substrat S2 comporte ensuite une grille d'injection 14 isolée du substrat par une couche isolante mince et surplombant une région de substrat adjacente à la région 12. La région de substrat surplombée par la grille d'injection est une région 22 dopée dans un sens de déplétion, c'est-à-dire que si le substrat est de type P, la région 22 comporte des impuretés permettant d'inverser le type de conductivité pour réaliser une région peu dopée de type N.

Dans la pratique on choisira une région de type N comportant un dopage de l'ordre de quelques 10¹⁶ atomes par cm³.

Adjacente à la grille d'injection mais non à la diode d'entrée, on trouve ensuite une grille de stockage 16 surplombant une région de substrat 18 et isolée d'elle par une couche isolante mince. Cette région de substrat 18 présente un dopage qui est en principe celui du substrat et elle constitue une région de stockage de charges.

Les polarisations appliquées aux différentes régions semiconductrices sont les suivantes :

La référence de tension est par exemple le substrat S2 de type P mis à la masse électrique (potentiel zéro volt).

On polarise la grille d'injection fortement négativement (entre -5 et -10 volts) de manière à tendre à créer à l'interface entre semiconducteur et isolant de grille une accumulation de porteurs positifs (qui viennent des régions dopées de type P+ inévitablement voisines du canal 22 et non visibles sur la figure 2).

Ces porteurs positifs maintiennent nécessairement l'interface au potentiel nul du substrat S2 et forment un écran qui rend le potentiel dans le canal insensible aux variations du potentiel Vi de la grille d'injection et surtout insensible aux variations de charges présentes dans l'isolant de grille ou à l'interface.

Le potentiel de la diode d'entrée 12 s'ajuste au voisinage de la tension de pincement de canal. Cette tension de pincement est la tension maximale dans le canal (le profil de potentiel dans le canal présente un maximum positif entre le potentiel nul dans le substrat sous le canal et le potentiel nul à l'interface) pour laquelle le canal est entièrement déserté de porteurs.

Dans un exemple de réalisation on trouvera par exemple que la tension de pincement est de l'ordre de 4 volts (mais elle peut être différente, par exemple 2 volts). On polarise alors le substrat S1 à un potentiel légèrement positif pour centrer la polarisation des photodiodes dans la plage de fonctionnement optimale. Le potentiel du premier substrat sera avantageusement un potentiel positif de quelques volts par rapport au potentiel du deuxième. Dans certains cas, cette polarisation peut ne pas s'avérer nécessaire, les substrats étant alors référencés à la masse.

Quant à la grille de stockage 16, elle est polarisée, comme dans la technique antérieure, à un potentiel Vs fortement positif (par exemple +5 à +10 volts) pour créer dans la région de stockage 18 un puits de potentiel suffisamment profond pour stocker des charges transitant sous la grille d'injection et venant de la région 12.

La structure qui vient d'être décrite permet de bien contrôler le potentiel de canal et de le rendre non seulement indépendant des variations de la tension Vi de la grille d'injection mais surtout indépendant des variations de charges de l'isolant de grille, contrairement à la technique antérieure dans laquelle, pour une tension de grille Vi donnée, le potentiel de canal sous la grille variait beaucoup en fonction de différents paramètres et notamment la charge de l'isolant le grille.

Ici, les charges positives libres qui viennent s'accumuler à la surface du canal (attirées par le potentiel fortement négatif de la grille) forment un écran électrostatique entre les charges de l'isolant et le canal. Comme ces charges positives sont en communication directe avec le substrat, ces charges restent au potentiel du substrat et l'écran est bien à potentiel constant.

Le dispositif fonctionne par suite de la présence de la région diffusée 22 de type N qui crée dans le canal un profil de potentiel tel que celui qui est représenté à la figure 3, c'est-à-dire un potentiel nul dans le substrat, devenant positif lorsqu'on entre dans le canal et redevenant nul à la surface du canal. Le maximum de potentiel positif dans le canal est pratiquement indépendant des potentiels de grille et de la présence de charges dans l'isolant.

Les porteurs positifs qui viennent faire écran à la surface du canal sous la grille viennent du substrat dopé de type P. Plus précisément ils parviennent à la surface du canal par la périphérie de celui-ci: en pratique le passage des charges sera souvent facilité par le fait que le canal est délimité dans un sens (non visible sur la figure) par des zones d'oxyde épais recouvrant des zones surdopées de type P⁺. Ces zones P⁺ sont immédiatement adjacentes au canal et libèrent des charges positives libres qui peuvent très facilement passer à la surface du canal, attirées par le potentiel négatif de la grille d'injection.

Cette structure d'injection présente deux autres avantages. Le premier avantage supplémentaire réside dans la fiabilité du dispositif. En effet, les grilles d'injection classiques de ce type de senseurs sont sujettes au vieillissement du diéléctrique actif par suite d'injection de porteurs dits "chauds" dans le diéléctrique sous la grille d'injection; ce problème, causé par les électrons chauds, est particulièrement important avec ce type de senseurs infrarouge parce qu'ils favorisent le fonctionnement à des basses températures qui favorisent la création de porteurs chauds.

Selon l'invention, la structure n'est pratiquement plus sensible à ce type de problèmes parce que les charges injectées ne se déplacent plus à l'interface substrat/diélectrique, mais en profondeur dans le substrat; les électrons qui circulent dans le canal enterré n'ont pratiquement plus la possibilité d'être injectés dans le diéléctrique.

Le deuxième avantage supplémentaire prend son origine également dans la présence de ce canal enterré: dans les structures d'injection classiques, le courant d'injection subit des interactions de type capacitives avec les pièges électriques, les défauts, créées par le vieillissement décrit précédemment, ou par l'environnement de radiations. Ces interactions affectent la qualité de l'injection et tendent à augmenter les variations de polarisations des diodes d'injection.

Selon l'invention, la structure possède une immunité complète vis-à-vis de ces interactions puisque les charges injectées se déplacent en volume et n'ont plus la possibilité d'interagir avec les pièges de l'interface substrat semiconducteur/diéléctrique.

Toutes les explications détaillées qui viennent d'être données supposent que les substrats sont de type P; s'ils étaient de type N il faudrait inverser tous les types de conductivité mentionnés et inverser les signes des différences de potentiel mentionnées.

## Revendications

1. Photosenseur hybride comprenant un premier substrat semiconducteur (S1) portant des éléments photosensibles (10) et un deuxième substrat semiconducteur (S2) comprenant, en correspondance avec chaque élément photosensible du premier substrat, un circuit de lecture pour convertir le courant issu de l'élément photosensible en paquets de charges, le circuit de lecture comportant une diode d'entrée constituée par une région semiconductrice (12) diffusée à l'intérieur du deuxième substrat et de type de conductivité opposé au substrat, une grille d'injection (14) adjacente à la diode d'entrée, et une grille de stockage (16) adjacente à la grille d'injection et non adjacente à la diode d'entrée, caractérisé en ce que le deuxième substrat est dopé superficiellement au-dessous de la grille d'injection avec une impureté du type opposé au substrat, en ce que la diode d'entrée est reliée à une source de tension de polarisation positive (VE) par rapport au deuxième substrat, pour un deuxième substrat de type P, et en ce que la grille d'injection est reliée à une source de tension de polarisation suffisamment négative (Vi) par rapport au deuxième substrat de type P, de façon à créer à la surface dudit deuxième substrat, sous la grille d'injection, une accumulation de porteurs libres du type de conductivité de base du deuxième substrat, les sens des potentiels étant inversés dans le cas d'un deuxième substrat de type N.

2. Photosenseur selon la revendication 1, caractérisé en ce que la tension négative (Vi) appliquée à la grille d'injection (14) est d'environ -5 à -10 volts.

3. Photosenseur selon l'une des revendications 1 ou 2, caractérisé en ce que le potentiel (VE) de la diode d'entrée est d'environ +2 à +4 volts par rapport au deuxième substrat (S2).

4. Photosenseur selon l'une des revendications 1 à 3, caractérisé en ce que le potentiel (VS1) du premier substrat (S1) est le même que celui du deuxième substrat (S2).

5. Photosenseur selon l'une des revendications 1 à 3, caractérisé en ce que le potentiel (VS1) du premier substrat (S1) est à une tension positive de plusieurs volts par rapport au deuxième substrat (S2) et proche du potentiel de la diode d'entrée.

## Patentansprüche

1. Hybrider Lichtsensor mit einem ersten Halbleitersubstrat (S1), das lichtempfindliche Elemente (10) trägt, und mit einem zweiten Halbleitersubstrat (S2), das gegenüber jedem lichtempfindlichen Element des ersten Substrats eine Leseschaltung enthält, um den Strom aus dem lichtempfindlichen Element in ein Ladungspaket umzuwandeln, wobei die Leseschaltung eine Eingangsdiode bestehend aus einer Halbleiterzone (12), die durch Diffusion im zweiten Substrat ausgebildet ist und die entgegengesetzte Leitfähigkeit des Substrats besitzt, ein Injektionsgate (14) neben der Eingangsdiode und ein Speichergate (16) neben dem Injektionsgate, aber nicht neben der Eingangsdiode enthält, dadurch gekennzeichnet, daß das zweite Substrat oberflächlich unter dem Injektionsgate mit Verunreinigungen entgegengesetzten Typs des Substrats dotiert ist, daß die Eingangsdiode an eine Vorspannungsquelle (VE) angeschlossen ist, die positiv bezüglich des zweiten Substrats ist, wenn ein zweites Substrat den Leitfähigkeitstyp P besitzt, und daß das Injektionsgate an eine ausreichend negative Vorspannungsquelle (Vi) bezüglich des zweiten Substrats vom Typ P angeschlossen ist, um an der Oberfläche des zweiten Substrats unter dem Injektionsgate eine Akkumulierung von freien Ladungsträgern des Basisleitfähigkeitstyps des zweiten Substrats zu bewirken, wobei die Polarität der Potentiale umgekehrt ist, wenn das zweite Substrat vom Typ N ist.

2. Lichtsensor nach Anspruch 1, dadurch gekennzeichnet, daß die negative Spannung (Vi), die an das Injektionsgate (14) angelegt wird, etwa -5 bis -10 Volt beträgt.

3. Lichtsensor nach einem der Ansprüche 1 und 2, dadurch gekennzeichnet, daß das Potential (VE) der Eingangsdiode etwa +2 bis +4 Volt bezüglich des Potentials des zweiten Substrats (S2) beträgt.

4. Lichtsensor nach einem der Ansprüche 1 bis 3, dadurch gekennzeichnet, daß das Potential (VS1) des ersten Substrats (S1) das gleiche wie das des zweiten Substrats (S2) ist.

5. Lichtsensor nach einem der Ansprüche 1 bis 3, dadurch gekennzeichnet, daß das Potential (VS1) des ersten Substrats (S1) mehrere Volt positiver als das Potential des zweiten Substrats (S2) ist und in der Nähe des Potentials der Eingangsdiode liegt.

## Claims

1. Hybrid photosensor comprising a first semiconductor substrate (S1) carrying photosensitive elements (10) and a second semiconductor substrate (S2) comprising, in correspondence with each photosensitive element of the first substrate, a read circuit for converting the current originating from the photosensitive element into charge packets, the read circuit including an input diode consisting of a semiconductor region (12) diffused within the second substrate and with the opposite type of conductivity to the substrate, an injection gate (14) adjacent to the input diode, and the storage gate (16) adjacent to the injection gate and not adjacent to the input diode, characterized in that the second substrate is doped superficially below the injection gate with an impurity of the opposite type to the substrate, in that the input diode is linked to a positive bias voltage source (VE) with respect to the second substrate, for a p-type second substrate, and in that the injection gate is linked to a bias voltage source which is sufficiently negative (Vi) with respect to the p-type second substrate as to create, at the surface of the said second substrate, under the injection gate, an accumulation of free carriers with the basic conductivity type of the second substrate, the directions of the potentials being reversed in the case of an n-type second substrate.

2. Photosensor according to Claim 1, characterized in that the negative voltage (Vi) applied to the injection gate (14) is from about -5 to -10 volts.

3. Photosensor according to either of Claims 1 and 2, characterized in that the potential (VE) of the input diode is from about +2 to +4 volts with respect to the second substrate (S2).

4. Photosensor according to one of Claims 1 to 3, characterized in that the potential (VS1) of the first substrate (S1) is the same as that of the second substrate (S2).

5. Photosensor according to one of Claims 1 to 3, characterized in that the potential (VS1) of the first substrate (S1) is at a positive voltage of several volts with respect to the second substrate (S2) and close to the potential of the input diode.
